(19) Europäisches Patentamt
European Patent Office
Office européen des brevets

(11) **EP 3 384 592 B1**

(12) **FASCICULE DE BREVET EUROPEEN**

(45) Date de publication et mention de la délivrance du brevet:
**22.04.2020 Bulletin 2020/17**

(21) Numéro de dépôt: **16806039.0**

(22) Date de dépôt: **01.12.2016**

(51) Int Cl.:
*H02S 50/00* *(2014.01)*      *H02S 50/10* *(2014.01)*

(86) Numéro de dépôt international:
**PCT/EP2016/079466**

(87) Numéro de publication internationale:
**WO 2017/093420 (08.06.2017 Gazette 2017/23)**

(54) **PROCEDE ET DISPOSITIF DE DETECTION D'UN ARC ELECTRIQUE DANS UNE INSTALLATION PHOTOVOLTAÏQUE**

VERFAHREN UND VORRICHTUNG ZUR ERKENNUNG VON LICHTBÖGEN IN EINER FOTOVOLTAIKANLAGE

METHOD AND DEVICE FOR DETECTING AN ELECTRIC ARC IN A PHOTOVOLTAIC INSTALLATION

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **01.12.2015 FR 1561622**

(43) Date de publication de la demande:
**10.10.2018 Bulletin 2018/41**

(73) Titulaires:
• **Commissariat à l'Énergie Atomique et aux Énergies Alternatives**
**75015 Paris (FR)**
• **Socomec**
**67230 Benfeld (FR)**

(72) Inventeurs:
• **CHAINTREUIL, Nicolas**
**73800 Montmelian (FR)**
• **SIAT, Stéphane**
**67230 Obenheim (FR)**
• **KERN, Christian**
**68240 Sigolsheim (FR)**

(74) Mandataire: **Novaimo**
**Europa 1**
**362, avenue Marie Curie**
**Archamps Technopole**
**74166 Saint Julien-en-Genevois Cedex (FR)**

(56) Documents cités:
**CN-A- 104 092 440**      **US-A1- 2012 134 058**
**US-A1- 2014 373 894**

## Description

## Domaine technique de l'invention

L'invention concerne un procédé et un dispositif de détection d'un arc électrique dans une installation photovoltaïque. Elle concerne aussi une installation photovoltaïque équipée d'un tel dispositif.

## État de la technique

Les installations photovoltaïques fonctionnent à courant et tension électriques continues, ce qui est problématique en cas d'apparition d'un arc électrique. Un tel arc électrique peut par exemple apparaître à cause d'un défaut de connectique, suite à l'ouverture d'un connecteur en charge ou encore suite à une dégradation d'un connecteur par corrosion. En courant et tension continus, il n'y a pas d'extinction naturelle de l'arc électrique par passage par zéro de la tension et du courant, comme c'est généralement le cas en courant alternatif. L'arc électrique génère un plasma qui dégage une très forte chaleur pendant une durée importante. Un tel plasma est destructeur et souvent générateur d'incendie. Pour des raisons de sécurité, il est donc important de détecter la présence d'un éventuel arc électrique au sein d'une installation photovoltaïque et de l'interrompre afin d'éviter toute dégradation ou un incendie. Le document US2012/134058A décrit un système de détection d'un arc électrique.

Un arc électrique correspondant à un plasma qui apparaît entre deux électrodes constituées par exemple par deux extrémités d'un conducteur ouvert ou localement interrompu du fait d'une dégradation. L'apparition d'un arc électrique s'accompagne d'un front ou saut de tension de courte durée, positif ou négatif, de l'ordre de quelques microsecondes, et ayant une valeur en tension, appelée tension d'arc Varc, qui est caractéristique. Cette tension d'arc dépend du matériau des électrodes. Elle est généralement comprise entre 10V et 30V. Si les électrodes sont en cuivre par exemple, la tension d'arc Varc est de l'ordre de 12V. Il en résulte qu'une augmentation brutale, comprise entre 10V et 30V, d'une tension mesurée au sein d'une installation photovoltaïque est donc caractéristique de l'apparition d'un arc électrique dans l'installation. Le plasma de l'arc électrique jouant le rôle d'une résistance qui augmente au cours du temps, le front de tension initial est suivi d'une augmentation progressive de la tension mesurée jusqu'à atteindre une tension en circuit ouvert.

Une solution connue pour détecter un arc électrique dans une installation photovoltaïque s'appuie sur la détection d'un front de tension positif (ou négatif) caractérisé par une augmentation (ou une diminution) brutale de tension, d'une durée de quelques microsecondes et d'une valeur correspondant à la tension d'arc Varc, typiquement comprise entre 10V et 30V. A cet effet, on mesure par exemple la tension aux bornes d'un module photovoltaïque de l'installation. La mesure de tension aux bornes du module photovoltaïque permet de détecter un éventuel arc électrique localisé en dehors de ce module photovoltaïque. Elle ne permet cependant pas de détecter un arc électrique qui se produirait au sein du module photovoltaïque lui-même. Dans le cas d'une installation comportant plusieurs modules photovoltaïques, il convient donc de mesurer la tension aux bornes de plusieurs modules pour couvrir la totalité de l'installation. Une telle solution nécessite plusieurs capteurs de mesure et s'avère donc coûteuse.

Une autre solution connue pour détecter un arc électrique dans une installation photovoltaïque s'appuie sur la mesure du courant dans l'installation photovoltaïque et du bruit blanc introduit par l'arc électrique dans le signal de courant. Une telle solution ne requiert qu'un seul capteur de courant qui peut être installé n'importe où dans l'installation photovoltaïque, par exemple en entrée d'un onduleur interposé entre l'installation photovoltaïque et le réseau électrique et destiné à convertir le courant continu délivré par un courant alternatif. Une telle solution est moins coûteuse et plus flexible, mais elle manque de fiabilité.

La présente invention vient améliorer la situation.

## Objet de l'invention

A cet effet, l'invention concerne un procédé de détection d'un arc électrique dans une installation photovoltaïque comme décrit dans la revendication 1.

Le procédé de détection d'un arc électrique de l'invention repose sur une mesure du courant électrique produit par l'installation photovoltaïque, ou d'une grandeur électrique représentative ou image de ce courant électrique. Grâce à cela, un seul capteur de mesure est nécessaire pour surveiller la totalité de l'installation photovoltaïque. L'ajustement du seuil de saut de courant en fonction du courant produit par l'installation permet de tenir compte des fluctuations d'amplitude des sauts de courant causés par des arcs électriques, qui peuvent être dues à des variations du niveau d'éclairement de l'installation photovoltaïque et/ou à un décalage d'un point de fonctionnement d'un module photovoltaïque de l'installation par rapport à son point de puissance maximale. Il en résulte que le procédé de l'invention est simple, peu coûteux à mettre en œuvre, et robuste.

La phase d'augmentation du seuil peut être linéaire.

Avantageusement, la loi de variation du seuil comporte une phase de seuil de saut de courant constant pour des valeurs de courant délivré par l'installation photovoltaïque supérieures à une limite haute.

Dans un mode de réalisation particulier, pour la détection du saut de courant, on ajuste le seuil de saut de courant en fonction d'un courant moyen calculé sur une fenêtre temporelle d'une durée comprise entre 50µs et 500ms précédant le saut de courant.

Avantageusement, les valeurs mesurées représentatives du courant délivré par l'installation photovoltaïque étant échantillonnées, pour détecter un saut de courant, on enregistre un ensemble de 2N échantillons successifs, N constituant une profondeur de détection donnée, et on exécute un algorithme de détection de saut consistant à calculer la différence entre la somme des N échantillons les plus anciens et la somme des N échantillons les plus récents, et à vérifier si la différence calculée est supérieure, en valeur absolue, à un seuil de saut de courant ajusté.

Avantageusement encore, on exécute l'algorithme de détection de saut pour deux profondeurs de détection distinctes N et M, et on détecte un arc électrique seulement si on détermine que les différences calculées pour les deux profondeurs sont supérieures, en valeur absolue, aux seuils correspondants. Grâce à cela, on filtre des phénomènes basse fréquence et des phénomènes haute fréquence faisant varier le courant.

La taille N peut être adaptée de sorte à filtrer des variations dynamiques du courant de l'installation photovoltaïque caractérisées par une fréquence caractéristique appartenant à une bande de fréquences comprise entre 1Hz et 1000Hz.

La taille M peut être adaptée de à filtrer des variations dynamiques du courant de l'installation photovoltaïque caractérisées par une fréquence caractéristique appartenant à une bande de fréquences comprise entre 100kHz et 1000kHz.

Dans un mode de réalisation particulier, le procédé comprend une étape de détection d'une variation du niveau de bruit d'un signal des valeurs mesurées supérieure à une variation critique.

La détection d'une variation du niveau de bruit permet de compléter la détection d'un saut de courant afin de rechercher la présence d'un arc électrique dans l'installation. Elle permet notamment de détecter certains arcs électriques particuliers qui ne provoquent pas de saut de courant détectable. Grâce à cela, la détection d'arc électrique est encore plus robuste et fiable.

Avantageusement, les valeurs mesurées étant échantillonnées, lors de l'étape de détection d'une variation du niveau de bruit, on calcule la variance de valeurs mesurées échantillonnées sur une fenêtre d'échantillons glissante dans le temps.

Avantageusement encore, on exécute l'étape de détection d'une variation du niveau de bruit à plusieurs reprises sur les mêmes échantillons en modifiant des paramètres de sorte à détecter différents types d'arcs électriques spécifiques.

L'invention concerne aussi un dispositif de détection d'un arc électrique dans une installation photovoltaïque destinée à délivrer un courant électrique, comme décrit dans la revendication 11.

Avantageusement, le dispositif comprend un convertisseur analogique-numérique destiné à échantillonner les valeurs mesurées représentatives du courant délivré par l'installation photovoltaïque, des moyens de stockage de valeurs mesurées échantillonnées destinés à stocker un ensemble de 2N échantillons successifs, N constituant une profondeur de détection donnée, et en ce que le module de détection d'un saut de courant est agencé pour exécuter un algorithme de détection de saut consistant à calculer la différence entre la somme des N échantillons les plus anciens et la somme des N échantillons les plus récents, et à vérifier, si la différence calculée est supérieure, en valeur absolue, à un seuil de saut de courant ajusté.

Avantageusement encore, le dispositif comprend un module de détection d'une variation du niveau de bruit d'un signal formé par les valeurs mesurées supérieure à une variation critique.

L'invention concerne également un système de sécurité pour une installation photovoltaïque, caractérisé en ce qu'il comprend un dispositif de détection d'un arc électrique tel que défini ci-dessus et un dispositif d'intervention destiné à mettre l'installation photovoltaïque en sécurité en cas d'arc électrique.

L'invention concerne encore une installation photovoltaïque caractérisée en ce qu'elle comprend un dispositif de détection d'arc électrique tel que défini ci-dessus ou un système de sécurité tel que défini ci-dessus.

**Description sommaire des dessins**

L'invention sera mieux comprise à l'aide de la description suivante d'un mode de réalisation particulier du procédé de détection d'un arc électrique dans une installation photovoltaïque de l'invention et d'une forme de réalisation particulière d'un dispositif de détection correspondant, en référence aux dessins annexés sur lesquels :

- La figure 1 représente un schéma d'un exemple d'installation photovoltaïque intégrant le dispositif de détection de la figure 6 ;
- Les figures 2A et 2B représentent deux exemples de signaux de courant délivrés par une installation photovoltaïque comportant chacun un saut de courant causé par un arc électrique ;
- La figure 3 représente différentes courbes caractéristiques de courant-tension d'une installation photovoltaïques, soumise à différentes irradiances (ou puissances d'illumination) ;
- Les figures 4A et 4B représentent des lois ou caractéristiques de variation d'un seuil de saut de courant en fonction d'un courant nominal de l'installation photovoltaïque ;
- La figure 5 représente un organigramme du procédé de détection d'un arc électrique dans une installation photovoltaïque selon un mode de réalisation particulier de l'invention ;
- La figure 6 représente un schéma bloc fonctionnel d'une unité de traitement du dispositif de détection, adaptée pour mettre en œuvre des étapes de traitement du procédé de la figure 5.

## Description détaillée de modes de réalisation particuliers de l'invention

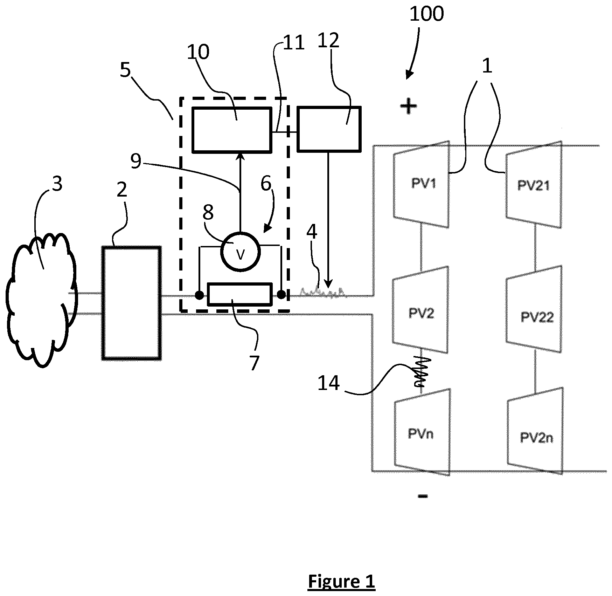

L'invention vise à détecter la présence d'un arc électrique au sein de l'installation photovoltaïque 100. Elle repose sur la mesure du courant électrique I fourni par l'installation photovoltaïque 100 ou d'une grandeur électrique représentative, ou image, de ce courant électrique I. Sur la figure 1, on a représenté schématiquement un exemple d'installation photovoltaïque 100. Celle-ci comprend, de façon connue, plusieurs modules photovoltaïques (PV) 1 reliés à un onduleur 2. Les modules PV 1 sont ici identiques. L'onduleur 2 est destiné à convertir le courant continu I produit par les modules photovoltaïques 2 en un courant alternatif et à fournir celui-ci à un réseau électrique 3.

Le procédé de l'invention cherche à détecter la présence ou non d'un arc électrique au sein d'une installation photovoltaïque 100. Un tel arc électrique peut se produire en tout endroit de l'installation 100, par exemple entre les modules photovoltaïques 1 et l'onduleur 2 (comme représenté par l'arc électrique 4 sur la figure 1), ou au sein d'un module photovoltaïque 1, ou encore sur une liaison reliant en série plusieurs modules photovoltaïques 1 (comme représenté par l'arc électrique 14 sur la figure 1).

Un arc électrique provoque une variation importante de la tension au sein de l'installation électrique 100. Dans un premier temps, l'apparition de l'arc électrique s'accompagne d'un front ou saut de tension, positif ou négatif, d'une durée de l'ordre de quelques microsecondes et d'une amplitude égale à une tension d'arc $V_{arc}$ caractéristique. La valeur de cette tension d'arc $V_{arc}$ est typiquement comprise entre 10V et 30V. Elle dépend du matériau d'électrodes entre lesquelles l'arc électrique se forme.

Un module photovoltaïque possède une caractéristique courant-tension qui lui est propre. Celle-ci peut être représentée sous la forme d'une courbe, généralement appelée « courbe I-V », comprenant un ensemble de points de fonctionnement du module photovoltaïque. La courbe I-V relie un point de fonctionnement en court-circuit, pour lequel la tension est nulle et le courant est égal au courant de court-circuit $I_{CC}$, et un point de fonctionnement en circuit ouvert, pour lequel le courant est nul et la tension est égale à la tension en circuit ouvert $V_{OC}$. La puissance électrique délivrée par le module photovoltaïque est le produit de la tension V à ses bornes par le courant I qu'il génère. Elle est maximale en un point spécifique de la courbe défini par un courant donné $I_{mpp}$ et une tension donnée $V_{mpp}$. Ce point de puissance maximale MPP (de l'anglais « Maximum Power Point ») est situé dans une zone d'inflexion de la courbe courant-tension. La forme de la courbe I-V d'un module photovoltaïque dépend de l'irradiance reçue par le module, c'est-à-dire de la puissance d'énergie lumineuse reçue.

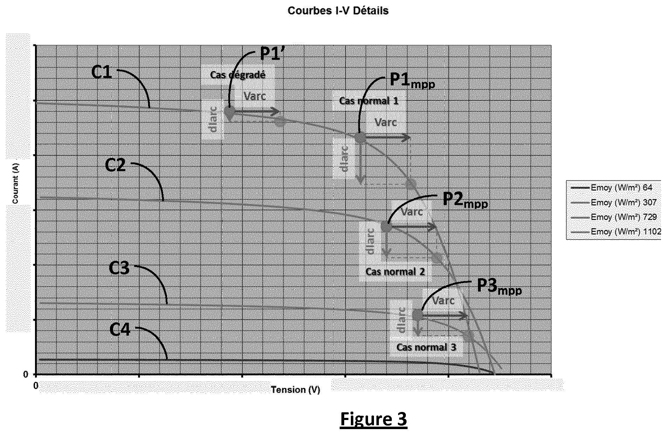

Sur la figure 3, on a représenté plusieurs courbes I-V, référencées C1 à C4, d'un même module photovoltaïque 1 soumis à différents niveaux d'éclairement ou d'irradiance :

- la courbe C1 correspond à un niveau d'éclairement moyen de 1102W/m²;
- la courbe C2 correspond à un niveau d'éclairement moyen de 729W/m²;
- la courbe C3 correspond à un niveau d'éclairement moyen de 307W/m²;
- la courbe C4 correspond à un niveau d'éclairement moyen de 64W/m².

Sur chacune des courbes C1, C2 et C3, on a représenté le point de puissance maximale $P1_{mpp}$, $P2_{mpp}$, $P3_{mpp}$. Sur la courbe C1, on a représenté un point de fonctionnement P1' décalé (vers la gauche) par rapport au point de puissance maximale $P1_{mpp}$. Généralement, l'installation photovoltaïque est réglée pour que les modules photovoltaïques qu'elle intègre fonctionne en leur point de puissance maximale. Toutefois, en raison par exemple d'un niveau d'éclairement non homogène sur les différents modules photovoltaïque de l'installation, un ou plusieurs modules peuvent avoir un point de fonctionnement décalé, tel que le point P1'.

Lorsqu'un arc électrique tel que l'arc électrique 4 ou 14 (figure 1) apparaît dans l'installation photovoltaïque 100, la tension aux bornes de chaque module photovoltaïque 1 augmente brutalement de la tension d'arc $V_{arc}$. Ce saut de tension, ici positif, d'amplitude $V_{arc}$ a pour effet de déplacer le point de fonctionnement du module photovoltaïque sur la courbe I-V, vers la droite, comme représenté sur la figure 3, jusqu'à un nouveau point de fonctionnement ayant une tension égale à $V_0+V_{arc}$ (où $V_0$ représente la tension du module photovoltaïque avant l'arc). Le déplacement du point de fonctionnement du module photovoltaïque s'accompagne d'un saut ici négatif (ou diminution ou chute) du courant de fonctionnement du module photovoltaïque 1, d'une amplitude $dI_{arc}$. Contrairement à l'amplitude du saut de tension qui est fixe et égale à $V_{arc}$, l'amplitude $dI_{arc}$ du saut de courant est variable. Elle varie selon la position du point de fonctionnement sur la courbe I-V et selon le niveau d'éclairement du module photovoltaïque. Par exemple, en référence à la courbe C1 de la figure 3, si le point de fonctionnement du module PV 1 est un point P1' décalé vers la gauche sur la courbe I-V par rapport au point de puissance maximale $P1_{mpp}$, le saut de courant a un amplitude $dI_{arc}$ très réduite. Par ailleurs, plus le niveau d'éclairement diminue, plus la courbe I-V s'aplatit et plus l'amplitude $dI_{arc}$ du saut de courant diminue, y compris pour le point de puissance maximale.

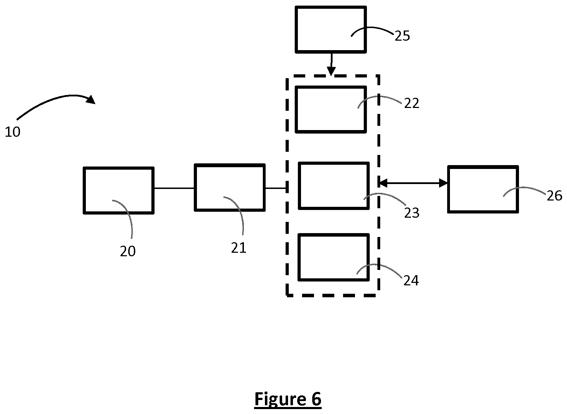

Sur la figure 1, on a représenté schématiquement un dispositif 5 de détection d'arc électrique, selon une forme de réalisation particulière de l'invention, pour l'installation photovoltaïque 100. Le dispositif de détection 5 comprend un module de mesure 6 destiné à mesurer le courant électrique I fourni par l'installation photovoltaïque 100, ou une grandeur électrique représentative ou image de ce courant électrique I. En l'espèce, le module de mesure 6 comprend une résistance shunt 7, placée sur une liaison électrique de l'installation photovoltaïque 100 (par exemple en entrée de l'onduleur 2 comme représenté sur la figure 6), et un capteur de mesure de tension 8 destiné à mesurer la tension aux bornes de la résistance 7. Le courant I fourni par l'installation photovoltaïque 100 est proportionnel à la tension U aux bornes de la résistance 7, selon la relation :

$I = \dfrac{1}{R} * U$ (R représentant la valeur de la résistance 7). La tension U mesurée ici est donc l'image du courant continu I délivré par l'installation photovoltaïque 100.

Le capteur de mesure 8 est relié par une liaison de communication 9 à une unité de traitement 10 destinée. L'unité de traitement 10 a pour fonction d'analyser les données et/ou signaux de mesure transmis par le capteur de mesure 8 afin de détecter la présence d'un éventuel arc électrique dans l'installation photovoltaïque. Elle comprend ici un convertisseur analogique-numérique 20 destiné à numériser ou échantillonner le signal de tension mesuré par le capteur 8 afin d'obtenir des valeurs de tension mesurées et échantillonnées qui sont représentatives du courant I de l'installation photovoltaïque. En variante, le convertisseur analogique-numérique pourrait être intégré dans le capteur de mesure 8. L'unité de traitement 10 a pour fonction de détecter un arc électrique par analyse des valeurs mesurées par le capteur 8 représentatives du courant électrique I fourni par l'installation photovoltaïque, par la mise en œuvre du procédé de détection d'un arc électrique qui sera décrit plus loin.

En référence à la figure 6, l'unité de traitement 10 comprend les composants matériels et/ou logiciels suivants :

- le convertisseur analogique-numérique 20 ;
- des mémoires de stockage 21 destinées à stockées des valeurs mesurées et échantillonnées et des données calculées ;
- un module 22 d'ajustement d'un seuil de courant variable, en fonction de valeurs mesurées représentatives du courant I de l'installation photovoltaïque 100 ;
- un module 23 de détection d'un saut de courant ayant une amplitude supérieure à un seuil de saut de courant ajusté en fonction de valeurs mesurées avant le saut ;
- un module 24 de détection d'une variation du niveau de bruit d'un signal formé par les valeurs mesurées ;
- un module de contrôle 25, destiné à commander les fonctionnements respectifs des modules 21, 22 et 23 et à déterminer la présence ou non d'un arc électrique dans l'installation 100 en fonction de résultats fournis par le module de détection 22 et/ou par le module de détection 23

- une unité de calcul 26, en l'espèce un microcontrôleur, destinée à mettre en œuvre des traitements et calculs de données et à contrôler le fonctionnement de l'unité de traitement 10.

Les modules 22 à 25 sont ici des composants logiciels destinés à être exécutés par le microcontrôleur 26.

Les composants matériels et/ou logiciels de l'unité de traitement 10 sont adaptés pour mettre en œuvre le procédé décrit plus loin.

L'unité de traitement 10 est reliée à un dispositif d'intervention 12 par une liaison de communication 11. Le dispositif d'intervention 12 a pour fonction d'interrompre un arc électrique détecté par l'unité de traitement 10, sur commande de celle-ci, afin d'éviter tout risque de détérioration ou d'incendie.

Le dispositif 5 de détection d'arc électrique et le dispositif d'intervention 12 forment un système de sécurité pour installation photovoltaïque.

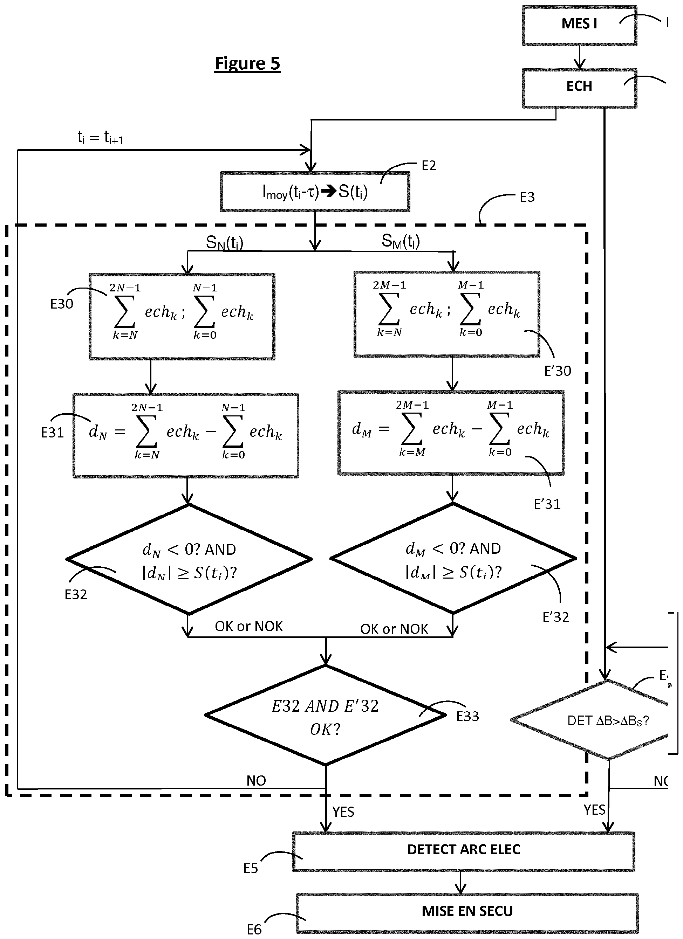

Un mode de réalisation particulier du procédé de détection d'un arc électrique dans l'installation photovoltaïque 100 destinée à délivrer un courant électrique I va maintenant être décrit en référence à la figure 5.

Le procédé comprend une étape E0 de mesure de valeurs de tension aux bornes de la résistance 7. Les valeurs de tension mesurées sont proportionnelles et donc représentatives, ou images, du courant électrique I délivré par l'installation photovoltaïque 100. En définitive, la mesure réalisée revient à mesurer le courant I délivré par l'installation photovoltaïque 100, à un facteur multiplicatif près. On pourrait en variante remplacer la résistance 7 et le capteur de mesure de tension 8 par un capteur de mesure de courant. Le signal mesuré, représentatif du courant I, est transmis à l'unité de traitement 10.

L'étape de mesure E0 est suivie d'une étape d'échantillonnage E1, lors de laquelle le signal mesuré est échantillonné avec une fréquence d'échantillonnage $F_{ech}$ choisie. Celle-ci peut être comprise entre 50kHz et 1000kHz. Ainsi les valeurs mesurées représentatives du courant I de l'installation photovoltaïque 100 sont numérisées par échantillonnage en données représentatives du courant I, que l'on appellera par la suite « données de courant ». L'échantillonnage est ici exécuté par le convertisseur CAN 20 du dispositif de traitement 10. En variante, dans le cas d'un capteur de mesure intégrant un convertisseur analogique-numérique, il pourrait être réalisé par le capteur lui-même. Les données de courant numérisées sont enregistrées dans des mémoires 21. Par exemple, on utilise trois mémoires tampons ou « buffers » ayant chacune une capacité de stockage de 256 points ou échantillons.

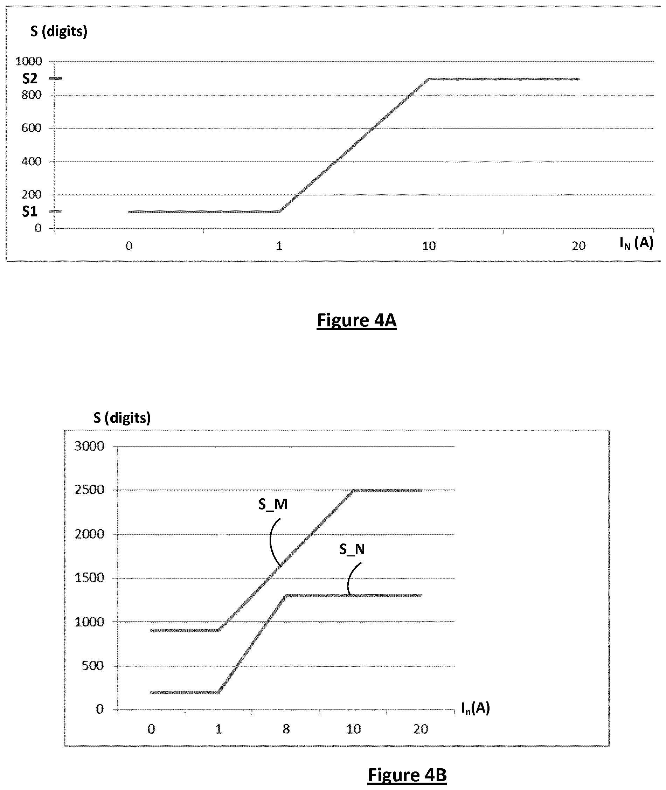

Le procédé comprend ensuite une étape E2 d'ajustement d'un seuil de saut de courant S. La détection d'un arc électrique selon l'invention repose sur la détection d'un saut de courant, tel que représenté sur la figure 1, ayant une amplitude supérieure à un seuil de saut de courant déterminé S. Ce seuil de saut de courant S est variable et doit être ajusté au cours du temps en fonction des valeurs mesurées représentatives du courant I de l'installation photovoltaïque 100. L'ajustement du seuil S est effectué selon une loi de variation du seuil de saut de courant en fonction du courant nominal $I_n$ de l'installation 100, telle que représentée à titre d'exemple illustratif sur la figure 4A. Par courant « nominal » $I_n$, on entend désigner le courant délivré par l'installation photovoltaïque 100 dans des conditions normales de fonctionnement (notamment sans arc électrique), chaque module photovoltaïque 1 de l'installation 100 fonctionnant en un point de fonctionnement de sa courbe I-V. En référence à la figure 4A, la loi de variation du seuil S comporte ici :

- une première phase à seuil de saut de courant constant S1 pour des valeurs de courant nominal $I_n$ de l'installation photovoltaïque 100 inférieures à une limite basse comprise entre 0A et 8A, avantageusement entre 0,8A et 1,2A, par exemple égale à 1A ;
- une deuxième phase à seuil de saut de courant constant S2 pour des valeurs de courant nominal $I_n$ de l'installation photovoltaïque supérieures à une limite haute, ici égale à 10A (à titre d'exemple illustratif) ;
- une phase intermédiaire de variation croissante, ou d'augmentation, du seuil de saut de courant en fonction du courant nominal $I_n$, l'augmentation étant ici linéaire, pour des courants compris entre la limite basse (ici 1A) et la limite haute (ici 10A).

Ainsi, selon la loi de variation telle que représentée sur la figure 4A, le seuil de saut de courant S est égal à une première valeur S1, lorsque le courant nominal $I_n$ de l'installation photovoltaïque 100 est inférieur ou égal à la limite basse (ici 1A), puis augmente de façon linéaire jusqu'à atteindre une deuxième valeur S2 lorsque le courant nominal $I_n$ de l'installation photovoltaïque 100 est égal à la limite haute (ici 10A) et enfin stagne à cette valeur S2 lorsque le courant nominal $I_n$ de l'installation photovoltaïque 100 est supérieur à la limite haute (ici 10A). Sur la figure 4A, les valeurs de seuil sont exprimées en digits. La numérisation de la valeur du courant donne des données en palier qui correspondent à un nombre de digits. Le digit représente donc une résolution en courant. Par exemple si un digit représente 0,1A, 100 digits représentent 10A. Dans l'exemple particulier de réalisation décrit ici, 1A correspond à 113 digits. D'une manière générale, 1A pourrait correspondre à un nombre de digits compris par exemple entre 50 et 400. On pourrait envisager d'autres formes de loi de variation du seuil de saut de courant en fonction du courant nominal (ou de fonctionnement) de l'installation photovoltaïque 100.

Lors de l'étape E2, afin de déterminer le seuil ajusté S valable à un instant donné $t_i$, noté $S(t_i)$, le module traitement 10 calcule une valeur moyenne du courant I sur une fenêtre d'analyse contenant une série de X valeurs mesurées et échantillonnées, autrement dit une série de X échantillons, couvrant une période temporelle légèrement antérieure à l'instant $t_i$, centrée sur un instant $(t_i-\tau)$ où $\tau$ représente un décalage temporel. La fenêtre d'analyse ne doit toutefois pas être trop éloignée de l'instant $t_i$, et contenir un nombre suffisant et raisonnable d'échantillons pour tenir compte d'éventuelles variations et acquérir l'information suffisamment rapidement. La durée de la fenêtre est par exemple comprise entre 10μs et 500ms. Elle couvre une période précédant le saut. Le décalage temporel ($\tau$) doit être au minimum d'un buffer (soit 256 échantillons) et avantageusement inférieur à 100 buffers. On note « $FA(t_i-\tau)$ » cette fenêtre d'analyse et « $I_{moy}(t_i-\tau)$ » la valeur moyenne du courant I calculée sur cette fenêtre d'analyse. Ainsi, le seuil $S(t_i)$ qu'il convient d'appliquer à l'instant $t_i$ est calculé sur la base d'une fenêtre d'analyse $FA(t_i-\tau)$ légèrement décalée dans le temps avant cet instant $t_i$ et centrée sur un instant $(t_i-\tau)$. Ce léger décalage temporel est adapté de sorte à ce que, en cas de saut de courant du courant I à l'instant $t_i$, ou sensiblement à l'instant $t_i$, la valeur moyenne de courant $I_{moy}(t_i-\tau)$ utilisée pour déterminer le seuil applicable $S(t_i)$ corresponde au courant moyen fourni par l'installation photovoltaïque 100 juste avant le saut. Le seuil S est ainsi mis à jour, ou ajusté, à chaque instant $t_i$ d'une succession d'instant $t_i$ avec i = 1, 2, .... Le seuil $S(t_i)$ est calculé en utilisant la loi de variation prédéfinie, telle que représentée sur la figure 4A, pour un courant « nominal » égal à la valeur moyenne de courant $I_{moy}(t_i-\tau)$ déterminée.

Le procédé comprend ensuite une étape E3 de détection d'un saut de courant. Cette étape est mise en œuvre à chaque instant $t_i$ à partir de données de courant préalablement enregistrées. Elle vise à détecter une chute de courant d'une amplitude supérieure au seuil de saut de courant ajusté et valable à cet instant $t_i$. La détection d'un saut de courant utilise un algorithme de détection tel que décrit ci-après.

L'algorithme de détection de saut utilise un ensemble de 2N échantillons successifs enregistrés, autrement dit 2N valeurs échantillonnées représentatives du courant I. Le nombre « N » constitue une profondeur de détection (ou d'analyse ou de traitement). Notons $ech_k$ l'échantillon d'indice k. L'algorithme comprend la mise en œuvre des étapes suivantes :

- calculer la somme des N échantillons $ech_k$ les plus récents d'indice k variant de 0 à N-1, et la somme des N échantillons $ech_k$ les plus anciens d'indice k variant de N à 2N-1 (les N échantillons $ech_k$ « les plus récents » ayant été mesurés postérieurement aux N échantillons « les plus anciens »), lors d'une première étape de calcul E30 ;

- puis calculer la différence $d_N$ entre la somme des N échantillons les plus anciens d'indice k variant de N à 2N-1 et la somme des N échantillons les plus récents d'indice k variant de 0 à N-1, soit

$$d_N = \sum_{k=N}^{2N-1} ech_k - \sum_{k=0}^{N-1} ech_k,$$ lors d'une deuxième étape de calcul E31 ;

- vérifier si la différence $d_N$ calculée est supérieure, en valeur absolue, au seuil $S(t_i)$ déterminé pour l'instant $t_i$ (par comparaison avec ce seuil) lors d'une étape de test E32.

Dans le mode de réalisation décrit ici, l'algorithme de détection de saut est exécuté pour une première profondeur de détection N, par la mise en œuvre des étapes E30 à E32, et pour une deuxième profondeur de détection M, par la mise en œuvre des étapes E'30 à E'32 analogues aux étapes E30 à E32 mais avec un changement de profondeur. La profondeur M est strictement supérieure à la profondeur N. Dans l'exemple de réalisation décrit ici, N est égal à 8 et M est égal à 128. Sur la figure 4B, on a représenté deux courbes de seuil S_N et S_M correspondant aux lois de variation du seuil exprimé en digits en fonction du courant nominal $I_n$ de l'installation photovoltaïque 100, respectivement applicables pour la profondeur N et pour la profondeur M. A un seuil $S(t_i)$ exprimé en ampères correspond deux seuils équivalents $S_N(t_i)$ et $S_M(t_i)$ exprimés en digits et applicables pour les profondeurs N et M respectivement.

L'exécution de l'algorithme de détection de saut pour deux profondeurs de détection N et M distinctes permet de filtrer des variations dynamiques basse fréquence (pour la profondeur N) et des variations dynamiques haute fréquence (pour la profondeur M), du courant de l'installation photovoltaïque 100. Ces variations dynamiques du courant I sont dues à des événements autres que des arcs électriques. Par exemple, il peut s'agit d'une baisse du courant produit par l'installation 100 en raison d'un nuage qui fait décroître l'éclairement reçu ou de variations de courant liés à des phénomènes parasites impulsionnels. La profondeur N est adaptée de sorte à filtrer des variations dynamiques du courant I de l'installation photovoltaïque 100 caractérisées par une fréquence caractéristique appartenant à une bande de fréquences comprise entre 1 Hz et 1000Hz. La profondeur M est adaptée de sorte à filtrer des variations dynamiques du courant I de l'installation photovoltaïque 100 caractérisées par une fréquence caractéristique appartenant à une bande de fréquences comprise entre 100kHz et 1000kHz. Plus généralement, les valeurs de N et M peuvent être choisies au sein d'une large plage, entre 3 et 1500, pour obtenir des résultats satisfaisants à partir d'une fréquence d'échantillonnage comprise entre 50kHz et 10MHz.

Lors d'une étape de test E33, on détermine si les deux étapes de comparaison E32 et E'32 fournissent des résultats positifs, autrement dit si les différences $d_N$ et $d_M$ calculées pour les deux profondeurs N et M sont supérieures aux seuils respectifs. Si le test E33 est positif, les différences $d_N$ et $d_M$ calculées pour les deux profondeurs N et M étant toutes deux supérieures aux seuils respectifs, on détecte la présence d'un arc électrique dans l'installation photovoltaïque 100 lors d'une étape E5. Ainsi, on détecte un arc électrique seulement si les différences calculées pour les deux profondeurs N et M sont supérieures aux seuils correspondants. En cas de test négatif, les étapes précédentes sont réitérées à un instant ultérieur $t_{i+1}$.

Le procédé comprend également l'exécution d'un algorithme de détection d'une variation ΔB du niveau de bruit du signal mesuré par le capteur de mesure 8, lors d'une étape E4, permettant de détecter une augmentation du niveau de bruit supérieure à une variation seuil ou critique $ΔB_S$. Un arc électrique s'accompagne d'une augmentation du niveau de bruit du signal de courant I de l'installation photovoltaïque 100, due au bruit généré par le plasma de l'arc électrique. L'algorithme de détection d'une variation du niveau de bruit vise à détecter cette augmentation du niveau de bruit à partir des valeurs mesurées représentatives du courant I de l'installation photovoltaïque 100, échantillonnées et enregistrées dans des mémoires tampons. A cet effet, on peut utiliser toute méthode connue de traitement du signal permettant de détecter la variation du niveau de bruit d'un signal.

Par exemple, l'algorithme de détection d'une variation du niveau de bruit peut reposer sur le calcul de la variance de valeurs mesurées échantillonnées, sur une fenêtre d'échantillons glissante dans le temps d'échantillons, et sur la détection d'un dépassement de seuil critique par cette variance.

En cas de détection d'une variation du niveau de bruit ΔB supérieure à la variation critique ou seuil $ΔB_S$, lors de l'étape E4, on détecte un arc électrique dans l'installation photovoltaïque et le procédé passe à l'étape E5.

En cas de non détection d'une variation du niveau de bruit ΔB supérieure à la variation critique ou seuil $ΔB_S$ lors de l'étape E4, le procédé réitère l'étape E5 pour une fenêtre d'analyse décalée dans le temps.

L'algorithme de détection d'une variation du niveau de bruit peut être exécuté plusieurs fois sur les mêmes échantillons en modifiant certains paramètres de l'algorithme de sorte à détecter différents types d'arcs électriques spécifiques ou à écarter une fausse détection d'arc électrique causée par un événement particulier (par exemple au démarrage de l'installation photovoltaïque à courant nominal au point de puissance maximale).

L'algorithme de détection d'une variation du niveau de bruit permet de compléter la détection réalisée par l'algorithme de détection d'un saut de courant. En particulier, dans les cas où l'arc électrique ne provoque pas de saut de courant ayant une amplitude suffisante pour être détecté (par exemple du fait d'un niveau d'éclairement faible de l'installation photovoltaïque ou du fait d'un point de fonctionnement décalé vers la gauche sur la courbe I-V par rapport au point de puissance maximale), l'algorithme de détection d'une variation du niveau de bruit permet néanmoins de détecter un éventuel arc électrique.

L'algorithme de détection d'un saut de courant et l'algorithme de détection d'une variation du niveau de bruit d'un saut de courant peuvent être exécutés en parallèle. On détecte la présence d'un arc électrique si l'une au moins des deux étapes E3 et E4 produit un résultat positif de détection d'arc électrique.

Lorsqu'un arc électrique est détecté (étape E5), l'unité de traitement 10 transmet une commande de mise en sécurité de l'installation photovoltaïque 100, lors d'une étape E6, au dispositif d'intervention 12. Cette mise en sécurité peut reposer sur des interrupteurs commandés à distance. Elle peut être réalisée par un ordre d'interruption du fonctionnement de l'installation photovoltaïque, ce qui permet de stopper l'arc électrique, en supprimant ainsi tout risque de dégradation et/ou d'incendie.

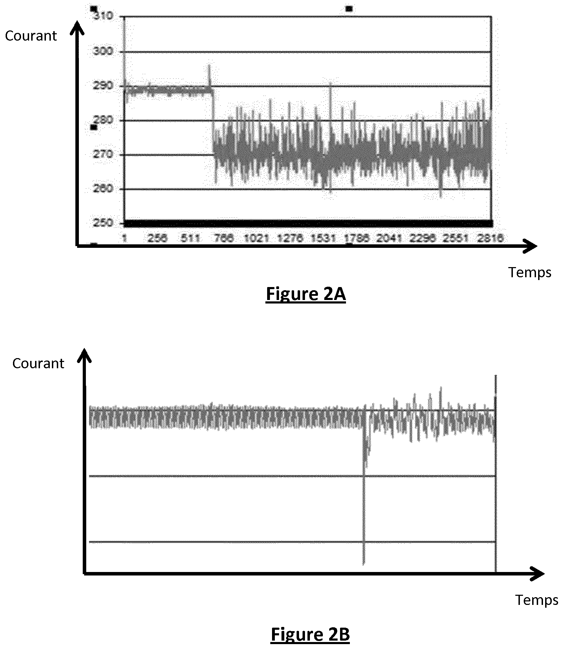

A titre d'exemple illustratif, les figures 2A et 2B représentent des signaux de courant mesurés avec présence d'un arc électrique. Sur la figure 2A, l'arc électrique provoque un saut négatif de courant qui sera détecté par l'étape E3 de détection d'un saut de courant, en cas de mise en œuvre du procédé de détection précédemment décrit. Sur la figure 2B, le courant revient très rapidement à sa valeur initiale après le saut de courant, avec une augmentation du niveau de bruit. Dans ce cas, l'arc électrique sera détecté par l'étape E4 de détection d'une variation du niveau de bruit, en cas de mise en œuvre du procédé de détection précédemment décrit.

## Revendications

1. Procédé de détection d'un arc électrique dans une installation photovoltaïque (100) destinée à délivrer un courant électrique (I) comprenant les étapes suivantes :

   • Mesure (E0) de valeurs représentatives du courant électrique (I) délivré par l'installation photovoltaïque (100) ;
   • Ajustement (E2) d'un seuil de saut de courant variable (S(ti)), en fonction de valeurs mesurées ;
   • Détection (E3) d'un saut de courant ayant une amplitude supérieure à un seuil de saut de courant ajusté en fonction de valeurs mesurées avant le saut ;
   • Détection (E5) d'un arc électrique sur détection d'un saut de courant, le procédé étant **caractérisé en ce que** l'ajustement (E2) du seuil de saut de courant variable utilise une loi de variation du seuil en fonction d'un courant nominal de l'installation photovoltaïque comportant une phase d'augmentation du seuil de saut de courant en fonction dudit courant nominal, la loi de variation du seuil comportant une phase de seuil de saut de courant constant pour des valeurs de courant nominal de l'installation photovoltaïque inférieures à une limite basse comprise entre 0A et 8A, avantageusement entre 0,8A et 1,2A, notamment égale à 1A.

2. Procédé selon la revendication 1, **caractérisé en ce que** la phase d'augmentation du seuil est linéaire.

3. Procédé selon la revendication 1 ou 2, **caractérisé en ce que** la loi de variation du seuil comporte une phase de seuil de saut de courant constant pour des valeurs de courant délivré par l'installation photovoltaïque supérieures à une limite haute.

4. Procédé selon l'une des revendications précédentes, **caractérisé en ce que**, pour la détection du saut de courant (E3), on ajuste le seuil de saut de courant en fonction d'un courant moyen calculé sur une fenêtre temporelle d'une durée comprise entre $50\mu s$ et 500ms précédant le saut de courant.

5. Procédé selon l'une des revendications précédentes, **caractérisé en ce que** les valeurs mesurées représentatives du courant délivré par l'installation photovoltaïque étant échantillonnées (E1), pour détecter un saut de courant, on enregistre un ensemble de 2N échantillons successifs, N constituant une profondeur de détection donnée, et on exécute un algorithme de détection de saut consistant à calculer (E31) la différence entre la somme des N échantillons les plus anciens et la somme des N échantillons les plus récents, et à vérifier (E32) si la différence calculée est supérieure, en valeur absolue, à un seuil de saut de courant ajusté.

6. Procédé selon la revendication précédente, **caractérisé en ce qu'**on exécute l'algorithme de détection de saut pour deux profondeurs de détection distinctes N et M (E31, E32, E'31, E'32), et on détecte un arc électrique seulement si on détermine que les différences calculées pour les deux profondeurs sont supérieures, en valeur absolue, aux seuils correspondants.

7. Procédé selon la revendication précédente, **caractérisé en ce que** : - la taille N est adaptée de sorte à filtrer des variations dynamiques du courant de l'installation photovoltaïque **caractérisées par** une fréquence caractéristique appartenant à une bande de fréquences comprise entre 1 Hz et 1000Hz ; ou - la taille M est adaptée de sorte à filtrer des variations dynamiques du courant de l'installation photovoltaïque **caractérisées par** une fréquence caractéristique appartenant à une bande de fréquences comprise entre 100kHz et 1000kHz.

8. Procédé selon l'une des revendications précédentes, **caractérisé en ce qu'**il comprend une étape (E4) de détection d'une variation du niveau de bruit d'un signal des valeurs mesurées supérieure à une

**9.** Procédé selon la revendication précédente, **caractérisé en ce que**, les valeurs mesurées étant échantillonnées, lors de l'étape de détection d'une variation du niveau de bruit, on calcule la variance de valeurs mesurées échantillonnées, notamment sur une fenêtre d'échantillons glissante dans le temps.

**10.** Procédé selon l'une des revendications 7 et 8, **caractérisé en ce qu'**on exécute l'étape de détection d'une variation du niveau de bruit à plusieurs reprises sur les mêmes échantillons en modifiant des paramètres de sorte à détecter différents types d'arcs électriques spécifiques.

**11.** Dispositif de détection d'un arc électrique dans une installation photovoltaïque (100) destinée à délivrer un courant électrique (I) comprenant les modules suivants : •un module (6) de mesure de valeurs représentatives du courant électrique (I) délivré par l'installation photovoltaïque (100) ; •un module (22) d'ajustement d'un seuil de saut de courant variable (S(ti)), en fonction de valeurs mesurées ; •un module (23) de détection d'un saut de courant ayant une amplitude supérieure à un seuil de saut de courant ajusté en fonction de valeurs mesurées avant le saut, le dispositif étant **caractérisé en ce que** l'ajustement du seuil de saut de courant variable utilise une loi de variation du seuil en fonction d'un courant nominal de l'installation photovoltaïque comportant une phase d'augmentation du seuil de saut de courant en fonction dudit courant nominal, la loi de variation du seuil comportant une phase de seuil de saut de courant constant pour des valeurs de courant nominal de l'installation photovoltaïque inférieures à une limite basse comprise entre 0A et 8A, avantageusement entre 0,8A et 1,2A, notamment égale à 1A.

**12.** Dispositif selon la revendication précédente, **caractérisé en ce qu'**il comprend un convertisseur analogique-numérique destiné à échantillonner les valeurs mesurées représentatives du courant délivré par l'installation photovoltaïque, des moyens de stockage de valeurs mesurées échantillonnées destinés à stocker un ensemble de 2N échantillons successifs, N constituant une profondeur de détection donnée, et **en ce que** le module (23) de détection d'un saut de courant est agencé pour exécuter un algorithme de détection de saut consistant à calculer la différence entre la somme des N échantillons les plus anciens et la somme des N échantillons les plus récents, et à vérifier, si la différence calculée est supérieure, en valeur absolue, à un seuil de saut de courant ajusté.

**13.** Dispositif selon l'une des revendications 11 et 12, **caractérisé en ce qu'**il comprend un module de détection d'une variation du niveau de bruit d'un signal formé par les valeurs mesurées supérieure à une variation critique.

**14.** Système de sécurité pour une installation photovoltaïque, **caractérisé en ce qu'**il comprend un dispositif de détection d'un arc électrique selon l'une des revendications 11 à 13 et un dispositif d'intervention destiné à mettre l'installation photovoltaïque en sécurité en cas d'arc électrique.

**15.** Installation photovoltaïque, **caractérisée en ce qu'**elle comprend un dispositif de détection d'arc électrique selon l'une des revendications 11 à 13 ou un système de sécurité selon la revendication 14.

**Patentansprüche**

**1.** Verfahren zur Erkennung eines Lichtbogens in einer Photovoltaikanlage (100), die dazu bestimmt ist, einen elektrischen Strom (I) abzugeben, umfassend die folgenden Schritte:

• Messen (E0) von Werten, die für den von der Photovoltaikanlage (100) abgegebenen elektrischen Strom (I) repräsentativ sind;
• Einstellen (E2) eines veränderlichen Stromsprungschwellenwerts (S(ti)) in Abhängigkeit von gemessenen Werten;
• Erkennen (E3) eines Stromsprungs mit ein Amplitude, die größer als ein Stromsprungschwellenwert ist, der in Abhängigkeit von vor dem Sprung gemessenen Werten eingestellt wurde;
• Erkennen (E5) eines Lichtbogens beim Erkennen eines Stromsprungs, wobei das Verfahren **dadurch gekennzeichnet ist, dass** das Einstellen (E2) des veränderlichen Stromsprungschwellenwerts eine Änderungsgesetzmäßigkeit des Schwellenwerts in Abhängigkeit von einem Nennstrom der Photovoltaikanlage verwendet, die eine Anstiegsphase des Stromsprungschwellenwerts in Abhängigkeit von dem Nennstrom umfasst, wobei die Änderungsgesetzmäßigkeit des Schwellenwerts eine konstante Stromsprungschwellenwertphase bei Nennstromwerten der Photovoltaikanlage umfasst, die kleiner als ein unterer Grenzwert sind, der zwischen 0A und 8A, vorteilhafterweise zwischen 0,8A und 1,2A liegt, insbesondere 1A beträgt.

**2.** Verfahren nach Anspruch 1, **dadurch gekennzeichnet, dass** die Anstiegsphase des Schwellenwerts linear ist.

**3.** Verfahren nach Anspruch 1 oder 2, **dadurch gekennzeichnet, dass** die Änderungsgesetzmäßigkeit des Schwellenwerts eine konstante Stromsprungschwellenwertphase für von der Photovoltaikanlage abgegebene Stromwerte umfasst, die größer als ein oberer Grenzwert sind.

4. Verfahren nach einem der vorhergehenden Ansprüche, **dadurch gekennzeichnet, dass** zur Erkennung des Stromsprungs (E3) der Stromsprungschwellenwert in Abhängigkeit von einem mittleren Strom eingestellt wird, der über ein Zeitfenster mit einer Dauer zwischen 50 µs und 500 ms berechnet wird, das dem Stromsprung vorausgeht.

5. Verfahren nach einem der vorhergehenden Ansprüche, **dadurch gekennzeichnet, dass**, wenn die für den von der Photovoltaikanlage abgegebenen Strom repräsentativen gemessenen Werte abgetastet werden (E1), zum Erkennen eines Stromsprungs eine Menge von 2N aufeinanderfolgenden Abtastwerten registriert wird, wobei N eine gegebene Erkennungstiefe darstellt, und ein Sprungerkennungsalgorithmus ausgeführt wird, der darin besteht, die Differenz zwischen der Summe der ältesten N Abtastwerte und der Summe der neuesten N Abtastwerte zu berechnen (E31) und zu überprüfen (E32), ob die berechnete Differenz als absoluter Wert größer als ein eingestellter Stromsprungschwellenwert ist.

6. Verfahren nach dem vorhergehenden Anspruch, **dadurch gekennzeichnet, dass** der Sprungerkennungsalgorithmus für zwei verschiedene Erkennungstiefen N und M durchgeführt wird (E31, E32, E'31, E'32) und ein Lichtbogen nur erkannt wird, wenn bestimmt wird, dass die für die beiden Tiefen berechneten Differenzen als absoluter Wert größer als die entsprechenden Schwellenwerte sind.

7. Verfahren nach dem vorhergehenden Anspruch, **dadurch gekennzeichnet, dass**:

- die Größe N so angepasst wird, dass dynamische Änderungen des Stroms der Photovoltaikanlage gefiltert werden, die durch eine charakteristische Frequenz gekennzeichnet sind, die einem Frequenzband zwischen 1 Hz und 1000 Hz angehört; oder
- die Größe M so angepasst wird, dass dynamische Änderungen des Stroms der Photovoltaikanlage gefiltert werden, die durch eine charakteristische Frequenz gekennzeichnet sind, die einem Frequenzband zwischen 100 kHz und 1000 kHz angehört.

8. Verfahren nach einem der vorhergehenden Ansprüche, **dadurch gekennzeichnet, dass** es einen Schritt (E4) des Erkennens einer Änderung des Rauschpegels eines Signals der gemessenen Werte umfasst, die größer als eine kritische Änderung ist.

9. Verfahren nach dem vorhergehenden Anspruch, **dadurch gekennzeichnet, dass**, wenn die gemessenen Werte abgetastet werden, beim Schritt des Erkennens einer Änderung des Rauschpegels die Varianz von abgetasteten gemessenen Werten berechnet wird, insbesondere über ein zeitlich gleitendes Abtastwertfenster.

10. Verfahren nach einem der Ansprüche 7 und 8, **dadurch gekennzeichnet, dass** der Schritt des Erkennens einer Änderung des Rauschpegels an denselben Abtastwerten mehrfach ausgeführt wird, wobei Parameter derart geändert werden, dass verschiedene spezifische Lichtbogentypen erkannt werden.

11. Vorrichtung zur Erkennung eines Lichtbogens in einer Photovoltaikanlage (100), die dazu bestimmt ist, einen elektrischen Strom (I) abzugeben, umfassend die folgenden Module:

• ein Modul (6) zum Messen von Werten, die für einen von der Photovoltaikanlage (100) abgegebenen elektrischen Strom (I) repräsentativ sind;
• ein Modul (22) zum Einstellen eines veränderlichen Stromsprungschwellenwerts (S(ti)) in Abhängigkeit von gemessenen Werten;
• ein Modul (23) zum Erkennen eines Stromsprungs mit einer Amplitude, die größer als ein Stromsprungschwellenwert ist, der in Abhängigkeit von vor dem Sprung gemessenen Werten eingestellt wurde, wobei die Vorrichtung **dadurch gekennzeichnet ist, dass** das Einstellen des veränderlichen Stromsprungschwellenwerts eine Änderungsgesetzmäßigkeit des Schwellenwerts in Abhängigkeit von einem Nennstrom der Photovoltaikanlage verwendet, die eine Anstiegsphase des Stromsprungschwellenwerts in Abhängigkeit von dem Nennstrom umfasst, wobei die Änderungsgesetzmäßigkeit des Schwellenwerts eine konstante Stromsprungschwellenwertphase bei Nennstromwerten der Photovoltaikanlage umfasst, die kleiner als ein unterer Grenzwert sind, der zwischen 0A und 8A, vorteilhafterweise zwischen 0,8A und 1,2A liegt, insbesondere 1A beträgt.

12. Vorrichtung nach dem vorhergehenden Anspruch, **dadurch gekennzeichnet, dass** sie einen Analog-DigitalWandler umfasst, der dazu bestimmt ist, die gemessenen Werte, die für den von der Photovoltaikanlage abgegebenen Strom repräsentativ sind, abzutasten, Mittel zum Speichern von abgetasteten gemessenen Werten, die dazu bestimmt sind, eine Menge von 2N aufeinanderfolgenden Abtastwerten zu speichern, wobei N eine gegebene Erkennungstiefe darstellt, und dass das Modul (23) zur Erkennung eines Stromsprungs dazu eingerichtet ist, einen Sprungerkennungsalgorithmus auszuführen, der darin besteht, die Differenz zwischen der Summe der ältesten N Abtastwerte und der Summe der neuesten N Abtastwerte zu berechnen und zu überprüfen, ob die berechnete Differenz als absoluter Wert größer als ein eingestellter Stromsprungschwellenwert ist.

13. Vorrichtung nach einem der Ansprüche 11 und 12, **dadurch gekennzeichnet, dass** sie ein Modul zur Erkennung einer Änderung des Rauschpegels eines durch die gemessenen Werte gebildeten Signals umfasst, die größer als eine kritische Änderung ist.

14. Sicherheitssystem für eine Photovoltaikanlage, **dadurch gekennzeichnet, dass** es eine Vorrichtung zur Erkennung eines Lichtbogens nach einem der Ansprüche 11 bis 13 umfasst und eine Vorrichtung zum Eingreifen, die dazu dient, die Photovoltaikanlage im Fall eines Lichtbogens zu sichern.

15. Photovoltaikanlage, **dadurch gekennzeichnet, dass** sie eine Vorrichtung zur Erkennung eines Lichtbogens nach einem der Ansprüche 11 bis 13 oder ein Sicherheitssystem nach Anspruch 14 umfasst.

**Claims**

1. A method for detecting an electric arc in a photovoltaic installation (100) intended to deliver an electric current (I), comprising the following steps:

   • Measuring (E0) values that are representative of the electric current (I) delivered by the photovoltaic installation (100);
   • Adjusting (E2) a variable current jump threshold ($S(t_i)$) as a function of measured values;
   • Detecting (E3) a current jump having a magnitude greater than a current jump threshold adjusted as a function of values measured before the jump;
   • Detecting (E5) an electric arc upon detection of a current jump,

   the method being **characterized in that** the adjustment (E2) of the variable current jump threshold uses a law of variation of the threshold as a function of a nominal current of the photovoltaic installation, including a phase of increasing the current jump threshold as a function of said nominal current, the law of variation of the threshold including a constant current jump threshold phase for nominal current values of the photovoltaic installation that are less than a lower limit of between 0 A and 8 A, advantageously between 0.8 A and 1.2 A, in particular equal to 1 A.

2. The method as claimed in claim 1, **characterized in that** the phase of increasing the threshold is linear.

3. The method as claimed in one of claims 1 or 2, **characterized in that** the law of variation of the threshold includes a constant current jump threshold phase for values of current delivered by the photovoltaic installation that are greater than an upper limit.

4. The method as claimed in one of the preceding claims, **characterized in that**, to detect the current jump (E3), the current jump threshold is adjusted as a function of an average current calculated over a temporal window of a duration between 50 μs and 500 ms preceding the current jump.

5. The method as claimed in one of the preceding claims, **characterized in that**, with the measured values that are representative of the current delivered by the photovoltaic installation being sampled (E1), to detect a current jump, a set of 2N successive samples is recorded, N constituting a given detection depth, and a jump detection algorithm is executed, consisting in calculating (E31) the difference between the sum of the N oldest samples and the sum of the N most recent samples, and in checking (E32) whether the calculated difference is greater, in absolute value, than an adjusted current jump threshold.

6. The method as claimed in the preceding claim, **characterized in that** the jump detection algorithm is executed for two different detection depths N and M (E31, E32, E'31, E'32), and an electric arc is detected only if it is determined that the differences calculated for the two depths are greater, in absolute value, than the corresponding thresholds.

7. The method as claimed in the preceding claim, **characterized in that** :

   - the size N is tailored so as to filter out dynamic variations in the current of the photovoltaic installation, which variations are **characterized by** a characteristic frequency belonging to a frequency band between 1 Hz and 1000 Hz ; or
   - the size M is tailored so as to filter out dynamic variations in the current of the photovoltaic installation, which variations are **characterized by** a characteristic frequency belonging to a frequency band between 100 kHz and 1000 kHz.

8. The method as claimed in one of the preceding claims, **characterized in that** it comprises a step (E4) of detecting a variation in the noise level of a signal of the measured values that is greater than a critical variation.

9. The method as claimed in the preceding claim, **characterized in that**, with the measured values being sampled, in the step of detecting a variation in the noise level, the variance of sampled measured values, in particular over a window of samples that slides over time, is calculated.

10. The method as claimed in either of claims 7 and 8, **characterized in that** the step of detecting a variation in the noise level is executed several times on the same samples while modifying parameters so as to detect various types of specific electric arcs.

11. A device for detecting an electric arc in a photovoltaic installation (100) intended to deliver an electric current (I), comprising the following modules:

   • a module (6) for measuring values that are representative of the electric current (I) delivered by the photovoltaic installation (100);
   • a module (22) for adjusting a variable current jump threshold ($S(t_i)$) as a function of measured values;
   • a module (23) for detecting a current jump having a magnitude greater than a current jump threshold adjusted as a function of values measured before the jump,

   the device being **characterized in that** the adjustment of the variable current jump threshold uses a law of variation of the threshold as a function of a nominal current of the photovoltaic installation, including a phase of increasing the current jump threshold as a function of said nominal current, the law of variation of the threshold including a constant current jump threshold phase for nominal current values of the photovoltaic installation that are less than a lower limit of between 0 A and 8 A, advantageously between 0.8 A and 1.2 A, in particular equal to 1 A.

12. The device as claimed in the preceding claim, **characterized in that** it comprises an analog-to-digital converter intended to sample the measured values that are representative of the current delivered by the photovoltaic installation, means for storing sampled measured values intended to store a set of 2N successive samples, N constituting a given detection depth, and **in that** the module (23) for detecting a current jump is designed to execute a jump detection algorithm, consisting in calculating the difference between the sum of the N oldest samples and the sum of the N most recent samples, and in checking whether the calculated difference is greater, in absolute value, than an adjusted current jump threshold.

13. The device as claimed in either of claims 11 and 12, **characterized in that** it comprises a module for detecting a variation in the noise level of a signal formed by the measured values that is greater than a critical variation.

14. A safety system for a photovoltaic installation, **characterized in that** it comprises a device for detecting an electric arc as claimed in one of claims 11 to 13 and an intervention device intended to protect the photovoltaic installation in the event of an electric arc.

15. A photovoltaic installation, **characterized in that** it comprises a device for detecting an electric arc as claimed in one of claims 11 to 13 or a safety system as claimed in claim 14.

EP 3 384 592 B1



**Figure 1**

**Figure 2A**

**Figure 2B**

**Courbes I-V Détails**

**Figure 3**

**Figure 4A**

**Figure 4B**

**Figure 5**

MES I  I

ECH

$t_i = t_{i+1}$

$$I_{moy}(t_i\text{-}\tau) \rightarrow S(t_i)$$ E2

E3

$S_N(t_i)$  $S_M(t_i)$

E30
$$\sum_{k=N}^{2N-1} ech_k \; ; \; \sum_{k=0}^{N-1} ech_k$$

$$\sum_{k=N}^{2M-1} ech_k \; ; \; \sum_{k=0}^{M-1} ech_k$$
E'30

E31
$$d_N = \sum_{k=N}^{2N-1} ech_k - \sum_{k=0}^{N-1} ech_k$$

$$d_M = \sum_{k=M}^{2M-1} ech_k - \sum_{k=0}^{M-1} ech_k$$
E'31

$d_N < 0?$ AND
$|d_N| \geq S(t_i)?$
E32

$d_M < 0?$ AND
$|d_M| \geq S(t_i)?$
E'32

OK or NOK  OK or NOK

$E32\ AND\ E'32$
$OK?$  E33

DET $\Delta B > \Delta B_S$?  E

NO

NO

YES

YES

**DETECT ARC ELEC**
E5

**MISE EN SECU**
E6

**Figure 6**

**EP 3 384 592 B1**

## RÉFÉRENCES CITÉES DANS LA DESCRIPTION

**Documents brevets cités dans la description**

- US 2012134058 A